# FASCICULE DE BREVET EUROPEEN

(11) **EP 3 871 255 B1**
(45) Date de publication et mention de la délivrance du brevet: **04.12.2024**
(21) Numéro de dépôt: 19789681.4
(22) Date de dépôt: 18.10.2019
(51) Int. Cl.: H01L 25/075, H01L 33/54, H01L 33/38, H01L 33/08, H01L 33/18, H01L 33/32

(54) **DISPOSITIF OPTOELECTRONIQUE A DIODES ELECTROLUMINESCENTES A EXTRACTION DE LUMIERE AMELIOREE ET UN PROCÉDÉ POUR SA FABRICATION**
OPTOELEKTRONISCHE VORRICHTUNG MIT LEUCHTDIODEN MIT VERBESSERTER LICHTEXTRAKTION UND EIN VERFAHREN ZU SEINER HERSTELLUNG
OPTOELECTRONIC DEVICE COMPRISING LIGHT-EMITTING DIODES WITH IMPROVED LIGHT EXTRACTION AND A METHOD FOR ITS FABRICATION

(30) Priorité: 22.10.2018 FR 1871254
(43) Date de publication de la demande: 01.09.2021
(73) Titulaire: Aledia, 38130 Echirolles (FR)
(72) Inventeur: DUPONT, Tiphaine, 38000 GRENOBLE (FR); ROBIN, Ivan-Christophe, 38000 GRENOBLE (FR)
(74) Mandataire: Cabinet Beaumont
(86) Numéro de dépôt international: PCT/EP2019/078320
(87) Numéro de publication internationale: WO 2020/083757

(56) Documents cités:
- US-A1- 2007 023 765
- US-A1- 2010 084 678
- US-A1- 2012 181 568
- US-A1- 2016 111 593

## Description

La présente demande de brevet revendique la priorité de la demande de brevet français FR18/71254.

### Domaine technique

La présente description concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes formées par des éléments tridimensionnels, notamment des microfils ou nanofils semiconducteurs.

### Technique antérieure

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière. Des exemples d'éléments tridimensionnels adaptés à la réalisation de diodes électroluminescentes sont des microfils ou nanofils comprenant un matériau semiconducteur à base d'un composé comportant majoritairement au moins un élément du groupe III et un élément du groupe V (par exemple du nitrure de gallium GaN), appelé par la suite composé III-V.

L'efficacité d'extraction de lumière (LEE, sigle anglais pour Light Extraction Efficiency) d'un dispositif optoélectronique est généralement définie par le rapport entre le nombre de photons qui s'échappent du dispositif optoélectronique et le nombre de photons émis par les diodes électroluminescentes. Il est souhaitable que l'efficacité d'extraction d'un dispositif optoélectronique soit la plus élevée possible.

Un inconvénient des dispositifs optoélectroniques existants est qu'une fraction des photons émis au sein de chaque diode électroluminescente ne s'échappe pas de la diode électroluminescente.

Le document US 2016/111593 A1 se rapporte à un dispositif optoélectronique comprenant des éléments semi-conducteurs filaires.

### Résumé de l'invention

Ainsi, un objet d'un mode de réalisation est de pallier au moins en partie les inconvénients des dispositifs optoélectroniques à diodes électroluminescentes, notamment à microfils ou nanofils, décrits précédemment et de leurs procédés de fabrication.

Un autre objet d'un mode de réalisation est d'accroître l'efficacité d'extraction du dispositif optoélectronique.

Un autre objet d'un mode de réalisation est de réduire la proportion de la lumière qui ne s'échappe pas de chaque diode électroluminescente.

Un autre objet d'un mode de réalisation est de réduire la proportion de la lumière émise par une diode électroluminescente qui est absorbée/piégée par les diodes électroluminescentes voisines.

Un mode de réalisation prévoit un dispositif optoélectronique comprenant :
- un support comprenant une face ;
- des diodes électroluminescentes reposant sur la face et comprenant des éléments semiconducteurs filaires, coniques, ou tronconiques ;
- pour chaque diode électroluminescente ou pour chaque groupe de diodes électroluminescentes, un bloc d'encapsulation au moins partiellement transparent au rayonnement émis par les diodes électroluminescentes et recouvrant la diode électroluminescente sur toute la paroi latérale de la diode électroluminescente ou le groupe de diodes électroluminescentes sur toute la paroi latérale de chaque diode électroluminescente, l'épaisseur maximale du bloc d'encapsulation étant comprise entre 1 µm et 30 µm, des interstices d'air étant présents entre les blocs d'encapsulation recouvrant des diodes électroluminescentes adjacentes ou des groupes adjacents de diodes électroluminescentes ; et
- une couche conductrice électriquement recouvrant les blocs d'encapsulation et au contact de chaque diode électroluminescente,
dans lequel l'indice de réfraction du bloc d'encapsulation recouvrant au moins l'une des diodes électroluminescentes ou l'un des groupes de diodes électroluminescentes est compris entre 1,3 et 1,6.

Un autre mode de réalisation prévoit un dispositif optoélectronique comprenant :
- un support comprenant une face ;
- des diodes électroluminescentes reposant sur la face et comprenant des éléments semiconducteurs filaires, coniques, ou tronconiques ;
- pour chaque diode électroluminescente ou chaque groupe de diodes électroluminescentes, un bloc d'encapsulation au moins partiellement transparent au rayonnement émis par les diodes électroluminescentes et recouvrant la diode électroluminescente sur toute la paroi latérale de la diode électroluminescente ou le groupe de diodes électroluminescentes sur toute la paroi latérale de chaque diode électroluminescente, l'épaisseur maximale du bloc d'encapsulation étant comprise entre 1 µm et 30 µm, des interstices d'air étant présents entre les blocs d'encapsulation recouvrant des diodes adjacentes ou des groupes adjacents de diodes électroluminescentes ; et
- une couche conductrice électriquement recouvrant les blocs d'encapsulation et au contact de chaque diode électroluminescente,
dans lequel le dispositif optoélectronique comprend, pour au moins l'un des blocs d'encapsulation, une couche diélectrique conforme recouvrant le bloc d'encapsulation, au moins partiellement transparente au rayonnement émis par les diodes électroluminescentes, l'indice de réfraction du bloc d'encapsulation étant compris entre 1,8 et 2,2, l'épaisseur de la couche diélectrique étant comprise entre 200 nm et 5 µm, et l'indice de réfraction de la couche diélectrique étant compris entre 1,3 et 1,6.

Selon un mode de réalisation, chaque élément semiconducteur est en un composé III-V.

Selon un mode de réalisation, chaque élément semiconducteur comprend du nitrure de gallium.

Selon un mode de réalisation, le diamètre moyen de chaque élément semiconducteur est compris entre 200 nm et 2 µm et le diamètre moyen de chaque bloc d'encapsulation est compris entre 3 µm et 30 µm.

Selon un mode de réalisation, le dispositif comprend, en outre, pour au moins une diode électroluminescente, une couche photoluminescente recouvrant le bloc d'encapsulation.

Selon un mode de réalisation, le dispositif comprend des lentilles recouvrant les blocs d'encapsulation, les interstices d'air étant présents entre les lentilles.

Selon un mode de réalisation, le dispositif comprend, en outre, un filtre angulaire recouvrant les lentilles.

Selon un mode de réalisation, le filtre angulaire comprend une couche au moins partiellement opaque à la lumière visible et traversée par des ouvertures.

Un autre mode de réalisation prévoit un procédé de fabrication d'un dispositif optoélectronique comprenant un support comprenant une face et des diodes électroluminescentes reposant sur la face et comprenant des éléments semiconducteurs filaires, coniques, ou tronconiques. Le procédé comprend la formation, pour chaque diode électroluminescente ou pour chaque groupe de diodes électroluminescentes, d'un bloc d'encapsulation au moins partiellement transparent au rayonnement émis par les diodes électroluminescentes et recouvrant la diode électroluminescente sur toute la paroi latérale de la diode électroluminescente ou le groupe de diodes électroluminescentes sur toute la paroi latérale de chaque diode électroluminescente, l'épaisseur maximale du bloc d'encapsulation étant comprise entre 1 µm et 30 µm, des interstices d'air étant présents entre les blocs d'encapsulation recouvrant des diodes électroluminescentes adjacentes ou des groupes adjacents de diodes électroluminescentes, et la formation d'une couche conductrice électriquement recouvrant les blocs d'encapsulation et au contact de chaque diode électroluminescente, dans lequel l'indice de réfraction du bloc d'encapsulation recouvrant au moins l'une des diodes électroluminescentes ou l'un des groupes de diodes électroluminescentes est compris entre 1,3 et 1,6.

Un autre mode de réalisation prévoit un procédé de fabrication d'un dispositif optoélectronique comprenant un support comprenant une face et des diodes électroluminescentes reposant sur la face et comprenant des éléments semiconducteurs filaires, coniques, ou tronconiques, le procédé comprenant la formation, pour chaque diode électroluminescente ou pour chaque groupe de diodes électroluminescentes, d'un bloc d'encapsulation au moins partiellement transparent au rayonnement émis par les diodes électroluminescentes et recouvrant la diode électroluminescente sur toute la paroi latérale de la diode électroluminescente ou le groupe de diodes électroluminescentes sur toute la paroi latérale de chaque diode électroluminescente, l'épaisseur maximale du bloc d'encapsulation étant comprise entre 1 µm et 30 µm, des interstices d'air étant présents entre les blocs d'encapsulation recouvrant des diodes électroluminescentes adjacentes ou des groupes adjacents de diodes électroluminescentes, et la formation d'une couche conductrice électriquement recouvrant les blocs d'encapsulation et au contact de chaque diode électroluminescente. Le dispositif optoélectronique comprend, pour au moins l'un des blocs d'encapsulation, une couche diélectrique conforme recouvrant le bloc d'encapsulation, et au moins partiellement transparente au rayonnement émis par les diodes électroluminescentes, l'indice de réfraction du bloc d'encapsulation étant compris entre 1,8 et 2,2, l'épaisseur de la couche diélectrique étant comprise entre 200 nm et 5 µm, et l'indice de réfraction de la couche diélectrique étant compris entre 1,3 et 1,6.

Selon un mode de réalisation, le procédé comprend la formation de lentilles recouvrant les blocs d'encapsulation.

Selon un mode de réalisation, le procédé comprend la formation d'une structure monobloc comprenant les lentilles, chaque lentille comprenant un logement et comprenant la fixation de la structure monobloc au support, les blocs d'encapsulation étant insérés dans les logements.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un dispositif optoélectronique à microfils ou nanofils ;
la figure 2 représente des courbes d'évolution de l'efficacité d'extraction de lumière du dispositif optoélectronique de la figure 1 en fonction de l'indice de réfraction d'un élément du dispositif ;
la figure 3 représente un autre mode de réalisation d'un dispositif optoélectronique à microfils ou nanofils ;
la figure 4 représente des courbes d'évolution de l'efficacité d'extraction de lumière du dispositif optoélectronique de la figure 3 en fonction de l'épaisseur d'une couche photoluminescente ;
la figure 5 représente un autre mode de réalisation d'un dispositif optoélectronique à microfils ou nanofils ;
la figure 6 représente un autre mode de réalisation d'un dispositif optoélectronique à microfils ou nanofils ;
la figure 7 représente des courbes d'évolution de l'intensité lumineuse émise par le dispositif optoélectronique de la figure 6 selon une direction donnée en fonction de l'inclinaison de la direction donnée avec la face avant du dispositif pour différentes épaisseurs de lentilles ;
la figure 8 représente une courbe d'évolution de la puissance lumineuse émise par le dispositif optoélectronique de la figure 6 dans un cône d'émission dont le demi-angle au sommet est de 20° en fonction de l'épaisseur des lentilles ;
la figure 9 représente un autre mode de réalisation d'un dispositif optoélectronique à microfils ou nanofils ;
la figure 10 représente un autre mode de réalisation d'un dispositif optoélectronique à microfils ou nanofils ;
la figure 11 illustre une étape d'un mode de réalisation d'un procédé de fabrication du dispositif optoélectronique représenté en figure 5 ;
la figure 12 illustre une étape ultérieure du procédé de fabrication ;
la figure 13 illustre une étape ultérieure du procédé de fabrication ;
la figure 14 illustre une étape ultérieure du procédé de fabrication ;
la figure 15 illustre une étape ultérieure du procédé de fabrication ;
la figure 16 illustre une étape ultérieure du procédé de fabrication ;
la figure 17 illustre une étape ultérieure du procédé de fabrication ;
la figure 18 illustre une étape ultérieure du procédé de fabrication ;
la figure 19 illustre une étape ultérieure du procédé de fabrication ;
la figure 20 illustre une étape ultérieure du procédé de fabrication ;
la figure 21 illustre une étape d'un mode de réalisation d'un procédé de fabrication du dispositif optoélectronique similaire à celui représenté en figure 9 ;
la figure 22 illustre une étape ultérieure du procédé de fabrication ;
la figure 23 illustre une étape d'un mode de réalisation d'un procédé de fabrication du dispositif optoélectronique représenté en figure 1 ;
la figure 24 illustre une étape ultérieure du procédé de fabrication ; et
la figure 25 illustre une étape ultérieure du procédé de fabrication.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, les moyens de polarisation des diodes électroluminescentes d'un dispositif optoélectronique sont bien connus et ne sont pas décrits.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un dispositif optoélectronique dans une position normale d'utilisation. En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %. Sauf précision contraire, les expressions "environ", "approximativement", "sensiblement", et "de l'ordre de" signifient à 10 % près, de préférence à 5 % près. Dans la suite de la description, on entend par "couche conductrice" une couche conductrice électriquement et on entend par "couche isolante" une couche isolante électriquement.

La présente description concerne des dispositifs optoélectroniques à éléments tridimensionnels, par exemple des éléments filaires, coniques ou tronconiques, notamment des microfils ou des nanofils.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1,5 µm, de préférence comprises entre 100 nm et 1,5 µm, plus préférentiellement entre 100 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

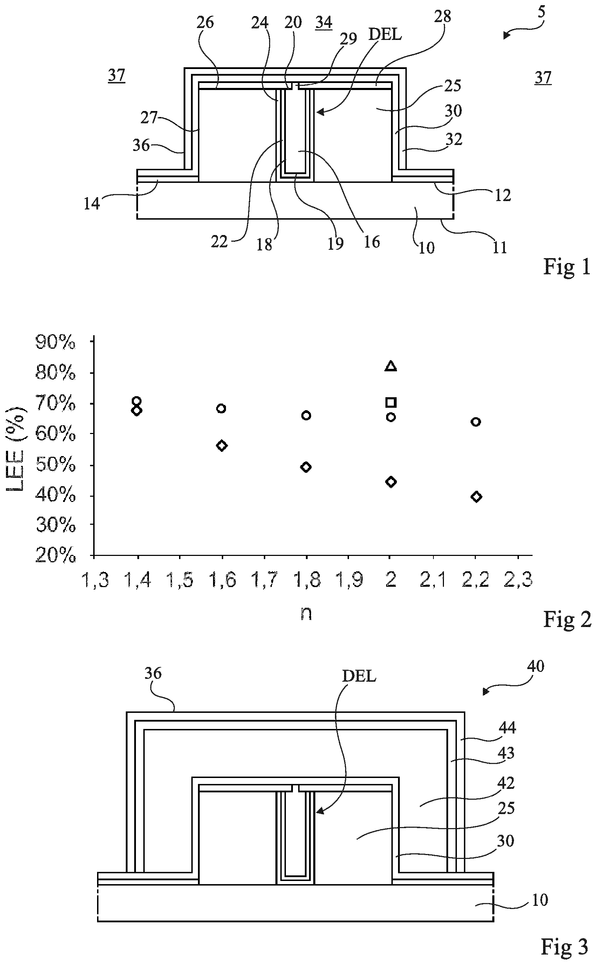

La figure 1 est une vue en coupe, partielle et schématique, d'un mode de réalisation d'un dispositif optoélectronique 5 à diodes électroluminescentes, une seule diode électroluminescente étant représentée.

En figure 1, on a représenté une structure comprenant, du bas vers le haut :
- un support conducteur 10 comprenant une face inférieure 11 et une face supérieure 12, la face supérieure 12 étant de préférence plane au moins au niveau des diodes électroluminescentes ;
- des diodes électroluminescentes DEL, une seule diode électroluminescente étant représentée de façon schématique en figure 1, chaque diode électroluminescente DEL comprenant un fil 16, comprenant une paroi latérale 18, une paroi d'extrémité inférieure 19 et une paroi d'extrémité supérieure 20, chaque diode électroluminescente DEL comprenant en outre une coque 22, comprenant un empilement de couches semiconductrices, recouvrant au moins en partie la paroi latérale 18 et recouvrant en totalité la paroi d'extrémité inférieure 19 ;
- pour chaque diode électroluminescente DEL, une couche conductrice 24 formant une première électrode, recouvrant la coque 22 et au contact de la coque 22, la couche conductrice 24 étant en outre interposée entre la portion de la coque 22 recouvrant la paroi d'extrémité inférieure 19 du fil 16 et le support 10 et étant au contact avec le support 10 ;
- pour chaque diode électroluminescente DEL, un bloc d'encapsulation isolant 25 reposant sur le support 10, entourant complètement la diode électroluminescente DEL et étant au contact de la première électrode 24 sur toute la paroi latérale de la diode électroluminescente DEL, le bloc d'encapsulation 25 comprenant une face supérieure 26 et une paroi latérale 27 ;
- une couche isolante 14 s'étendant sur la face 12 du support 10 autour des blocs d'encapsulation 25 ;
- pour chaque diode électroluminescente DEL, une couche isolante 28 s'étendant sur la face supérieure 26 du bloc d'encapsulation 25 et sur une partie de la paroi d'extrémité supérieure 20 du fil 16, le fil 16 comprenant une protubérance 29 au niveau de la paroi supérieure 20 s'étendant au travers de la couche isolante 28 ;
- une couche conductrice 30, formant une deuxième électrode, s'étendant, pour chaque diode électroluminescente, sur la paroi latérale 27 du bloc d'encapsulation 25 associé, sur la couche isolante 28 associée, et sur la couche isolante 14 entre les blocs d'encapsulation 25 et au contact des protubérances 29 de chaque diode électroluminescente DEL ; et
- une couche isolante 32 recouvrant la couche conductrice 30, et recouvrant notamment la totalité de la face supérieure 26 du bloc d'encapsulation 25 et la totalité de la paroi latérale 27 du bloc d'encapsulation 25.

Selon un autre mode de réalisation, la couche isolante 32 n'est pas présente. Selon un autre mode de réalisation, la couche isolante 32 est interposée entre la couche conductrice 30 et le bloc d'encapsulation 25.

Dans le présent mode de réalisation, les diodes électroluminescentes DEL sont connectées en parallèle et forment un ensemble de diodes électroluminescentes. A titre de variante, les électrodes 24 et 30 peuvent être agencées pour connecter différemment les diodes électroluminescentes.

Selon un mode de réalisation, la couche isolante 32 est en contact avec de l'air 34. La face avant 36 du dispositif optoélectronique 5 est la face vue par un observateur et comprend notamment les faces exposées à l'air 34 des blocs d'encapsulation 25, lorsque la couche 32 n'est pas présente, ou les faces exposées à l'air 34 de la couche 32 lorsque la couche 32 est présente. En particulier, un interstice d'air 37 est interposé entre chaque paire de diodes électroluminescentes adjacentes.

Selon un mode de réalisation, le matériau composant le bloc d'encapsulation 25 a un indice de réfraction optique, également appelé indice de réfraction, pour les longueurs d'onde du rayonnement émis par les diodes électroluminescentes DEL, inférieur strictement à l'indice de réfraction du matériau composant le fil 16 et supérieur strictement à l'indice de réfraction du matériau composant la couche isolante 32. L'indice de réfraction optique est un nombre sans dimension qui caractérise les propriétés optiques d'un milieu, notamment l'absorption et la diffusion. L'indice de réfraction est égal à la partie réelle de l'indice optique complexe. L'indice de réfraction peut être déterminé, par exemple, par ellipsométrie. Dans la suite de la description, sauf indication contraire, lorsqu'on parle d'indice de réfraction, il s'agit de l'indice de réfraction pour les longueurs d'onde du rayonnement émis par les diodes électroluminescentes DEL. Selon un mode de réalisation, le matériau composant la couche isolante 32 a un indice de réfraction optique inférieur strictement à l'indice de réfraction du matériau composant le bloc d'encapsulation 25 et supérieur strictement à l'indice de réfraction de l'air.

Le support 10 peut correspondre à une structure monobloc ou comprendre une base recouverte d'une couche conductrice. La face supérieure 12 est conductrice électriquement et est par exemple métallique, par exemple en aluminium, en argent, en cuivre ou en zinc. Le support 10 peut comporter différentes régions conductrices isolées électriquement entre elles. Ceci permet d'adresser indépendamment les différentes diodes électroluminescentes. Selon un mode de réalisation, la face 12 peut être réfléchissante. Le support 10 peut alors présenter une réflexion spéculaire. Selon un autre mode de réalisation, le support 10 peut alors présenter une réflexion lambertienne. Pour obtenir une surface présentant une réflexion lambertienne, une possibilité est de créer des irrégularités sur une surface conductrice. A titre d'exemple, lorsque la face 12 correspond à la face d'une couche conductrice reposant sur une base, une texturation de la surface de la base peut être réalisée avant le dépôt de la couche métallique pour que la face 12 de la couche métallique, une fois déposée, présente des reliefs.

Les fils 16 sont, au moins en partie, formés à partir d'au moins un matériau semiconducteur. Les fils 16 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires. Les fils 16 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La section droite des fils 16 peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. La hauteur de chaque fil 16 peut être comprise entre 250 nm et 50 µm. Chaque fil 16 peut avoir une structure semiconductrice allongée selon un axe sensiblement perpendiculaire à la face 12. Chaque fil 16 peut avoir une forme générale cylindrique. Les axes de deux fils 16 adjacents peuvent être distants de 0,5 µm à 10 µm et de préférence de 1,5 µm à 6 µm. A titre d'exemple, les fils 16 peuvent être régulièrement répartis, notamment selon un réseau hexagonal ou carré.

La coque 22 peut comprendre un empilement de plusieurs couches comprenant notamment :
- une couche active recouvrant au moins en partie la paroi latérale 18 et en totalité la paroi inférieure 19 du fil 16 associé ;
- une couche intermédiaire de type de conductivité opposé au fil 16 recouvrant la couche active ; et
- une couche de liaison recouvrant la couche intermédiaire et recouverte par l'électrode 24.

La couche active est la couche depuis laquelle est émise la majorité du rayonnement fourni par la diode électroluminescente DEL. Selon un exemple, la couche active peut comporter des moyens de confinement, tels qu'un puits quantique unique ou des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et le fil 16 de type N de la jonction P-N ou P-I-N. La couche de liaison peut correspondre à une couche semiconductrice ou à un empilement de couches semiconductrices et permet la formation d'un contact ohmique entre la couche intermédiaire et l'électrode 24. A titre d'exemple, la couche de liaison peut être dopée très fortement du type opposé au fil 16, jusqu'à dégénérer la ou les couches semiconductrices, par exemple dopée de type P à une concentration supérieure ou égale à 10²⁰ atomes/cm³. L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

Chaque électrode 24, 30 est adaptée à polariser la couche active de la diode électroluminescente DEL et à laisser passer le rayonnement électromagnétique émis par la diode électroluminescente DEL. Le matériau formant chaque électrode 24, 30 peut être un matériau transparent et conducteur tel que de l'oxyde d'indium-étain (ou ITO, acronyme anglais pour Indium Tin Oxide), de l'oxyde de zinc pur, de l'oxyde de zinc dopé à l'aluminium de l'oxyde de zinc dopé au gallium, du graphène, ou des nanofils d'argent. A titre d'exemple, chaque couche d'électrode 24, 30 a une épaisseur comprise entre 5 nm et 200 nm, de préférence entre 30 nm et 100 nm.

Chaque couche isolante 14, 28 et 32 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'aluminium (Al₂O₃), en oxyde d'hafnium (HfO₂) ou en diamant. A titre d'exemple, l'épaisseur de chaque couche isolante 14 et 28 est comprise entre 5 nm et 500 nm, par exemple égale à environ 30 nm. La couche 32 peut, en outre, être en un matériau organique, par exemple un polymère organique, ou en un matériau inorganique, par exemple du silicone. A titre d'exemple, l'épaisseur de la couche isolante 32, lorsqu'elle est présente, est comprise entre 200 nm et 5 µm, par exemple égale à environ 1 µm.

Le bloc d'encapsulation 25 peut être en un matériau organique ou un matériau inorganique au moins partiellement transparent au rayonnement émis par la diode électroluminescente DEL. L'épaisseur maximale du bloc d'encapsulation 25, mesurée perpendiculairement à la face 12, est de préférence comprise entre 1 µm et 30 µm. La largeur du bloc d'encapsulation 25 peut correspondre au diamètre du cercle circonscrit au bloc d'encapsulation en vue de dessus. Selon un mode de réalisation, la largeur du bloc d'encapsulation 25 est comprise entre 3 µm et 30 µm. Selon un mode de réalisation, la face supérieure 26 est plane et parallèle à la face 12. Selon un mode de réalisation, la paroi latérale 18 est perpendiculaire à la face 12. A titre de variante, la paroi latérale 18 peut être inclinée par rapport à la face 12.

Le bloc d'encapsulation 25 peut être réalisé en un matériau organique au moins partiellement transparent. Le bloc d'encapsulation 25 peut comprendre une matrice d'un matériau inorganique ou organique au moins partiellement transparent dans laquelle sont éventuellement réparties des particules d'un matériau diélectrique. L'indice de réfraction du matériau diélectrique composant les particules est strictement supérieur à l'indice de réfraction du matériau composant la matrice. Selon un exemple, le bloc d'encapsulation 25 comprend une matrice en silicone, également appelée polysiloxane, ou une matrice en un polymère époxyde et comprend, en outre, des particules d'un matériau diélectrique réparties dans la matrice. Les particules sont en tout type de matériau permettant l'obtention de particules de dimensions nanométriques relativement sphériques et ayant un indice de réfraction adapté. A titre d'exemple, les particules peuvent être en oxyde de titane (TiO₂), en oxyde de zirconium (ZrO₂), en sulfure de zinc (ZnS), en sulfure de plomb (PbS) ou en silicium amorphe (Si). On appelle diamètre moyen d'une particule le diamètre de la sphère de même volume. Le diamètre moyen des particules du matériau diélectrique est compris entre 2 nm et 250 nm. La concentration en volume des particules par rapport au poids total de la couche d'encapsulation 34 est comprise entre 1 % et 50 %. Selon un autre exemple, le bloc d'encapsulation 25 peut être dans l'un des matériaux décrits précédemment pour les couches isolantes 14, 28 et 32.

Lorsque la couche 32 n'est pas présente, le bloc d'encapsulation a un indice de réfraction compris entre 1,3 et 1,6. Lorsque la couche 32 est présente, le bloc d'encapsulation 25 a un indice de réfraction compris entre 1,8 et 2,2 et la couche isolante 32 a un indice de réfraction compris entre 1,3 et 1,6.

Le dispositif optoélectronique selon le mode de réalisation décrit précédemment permet de façon avantageuse d'augmenter l'efficacité d'extraction globale du dispositif optoélectronique 5, c'est-à-dire s'échappant du dispositif optoélectronique 5 par la face avant 36. Pour être perçue par un observateur regardant le dispositif optoélectronique 5, la lumière doit quitter les blocs d'encapsulation 25 par la face avant 36. Pour améliorer l'efficacité d'extraction du dispositif optoélectronique 5, un traitement de surface, appelé texturation, peut être appliqué à la face avant 36 de façon à former des reliefs sur la face 36.

Des simulations ont été réalisées pour le dispositif optoélectronique 5 représenté en figure 1. Pour ces simulations, le bloc d'encapsulation 25, recouvert de l'électrode 30, avait un diamètre externe de 5 µm, le support 10 étant en aluminium, l'électrode 24 était en TCO, l'électrode 30 était en TCO, le fil 16 et la coque 22 étaient en GaN, avaient une hauteur de 5 µm et un diamètre externe de 1,25 µm. Lorsque la couche 32 est présente, son indice de réfraction est pris égal à 1,45.

La figure 2 représente des courbes d'évolution de l'efficacité d'extraction de lumière LEE du dispositif optoélectronique 5 de la figure 1 en fonction de l'indice de réfraction n du bloc d'encapsulation 25. Les simulations indiquées par des losanges ont été obtenues en l'absence de la couche 32, en considérant que le support 10 en aluminium forme un miroir avec une réflexion spéculaire. Les simulations indiquées par des cercles ont été obtenues en l'absence de la couche 32, en considérant que le support 10 présente une réflexion lambertienne. La simulation indiquée par le carré a été obtenue en présence de la couche 32, en considérant que le support 10 en aluminium forme un miroir avec une réflexion spéculaire. La simulation indiquée par le triangle a été obtenue en présence de la couche 32, en considérant que le support 10 présente une réflexion lambertienne.

La figure 3 est une vue en coupe, partielle et schématique, d'un autre mode de réalisation d'un dispositif optoélectronique 40 à microfils ou nanofils. Le dispositif optoélectronique 40 comprend l'ensemble des éléments du dispositif optoélectronique 5 représenté en figure 1 et comprend en outre, au moins pour certaines diodes électroluminescentes DEL, une couche photoluminescente 42 recouvrant le bloc d'encapsulation 25. La couche photoluminescente 42 peut en outre jouer le rôle de la couche 32 décrite précédemment. La plage d'indices de réfraction de la couche photoluminescente 42 est alors celle décrite précédemment pour la couche 32. Le dispositif optoélectronique 40 peut en outre comprendre une couche transparente 43 recouvrant la couche photoluminescente 42 et un filtre 44 recouvrant la couche 43 configuré pour bloquer la transmission d'un rayonnement dans une plage de longueurs d'ondes donnée. Le filtre 44 peut correspondre à une couche colorée ou à un empilement de couches d'indices de réfraction différents formant un filtre de Bragg. La couche photoluminescente 42 peut être une couche conforme. Les filtres 44 permettent d'ajuster la plage de longueur d'onde du rayonnement qui s'échappe de la couche photoluminescente 42. La couche 43 a un indice de réfraction le plus proche possible de 1, de préférence inférieur à l'indice de réfraction de la couche 42, de préférence inférieur à 1,5, de façon à réduire, voire supprimer, les réflexions sur le filtre 44 des rayons s'échappant de la couche photoluminescente 42. La couche 43 est par exemple réalisée en MgF₂, en un polymère, par exemple un acrylate, ou correspond à un film d'air.

La couche photoluminescente 42 peut comprendre des luminophores adaptés, lorsqu'ils sont excités par la lumière émis par la diode électroluminescente DEL associée, à émettre de la lumière à une longueur d'onde différente de la longueur d'onde de la lumière émise par la diode électroluminescente DEL associée. L'épaisseur de la photoluminescente 42 peut être comprise entre 4 µm et 40 µm.

Selon un mode de réalisation, la couche photoluminescente 42 comprend des particules d'au moins un matériau photoluminescent. Un exemple d'un matériau photoluminescent est le grenat d'yttrium et d'aluminium (YAG) activé par l'ion cérium trivalent, également appelé YAG:Ce ou YAG:Ce3+. La taille moyenne des particules des matériaux photoluminescents classiques est généralement supérieure à 5 µm.

Selon un mode de réalisation, chaque couche photoluminescente 42 comprend une matrice dans laquelle sont dispersées des particules monocristallines de taille nanométrique d'un matériau semiconducteur, également appelées nanocristaux semiconducteurs ou particules de nanoluminophores par la suite. Le rendement quantique interne QYint d'un matériau photoluminescent est égal au rapport entre le nombre de photons émis et le nombre de photons absorbés par la substance photoluminescente. Le rendement quantique interne QYint des nanocristaux semiconducteurs est supérieur à 5 %, de préférence supérieur à 10 %, plus préférentiellement supérieur à 20 %.

Selon un mode de réalisation, la taille moyenne des nanocristaux est dans la plage de 0,5 nm et 1000 nm, de préférence de 0,5 nm à 500 nm, encore plus préférentiellement de 1 nm à 100 nm, notamment de 2 nm à 30 nm. Pour des dimensions inférieures à 50 nm, les propriétés de photoconversion des nanocristaux semiconducteurs dépendent essentiellement de phénomènes de confinement quantique. Les nanocristaux semiconducteurs correspondent alors à des boîtes quantiques (dans le cas d'un confinement dans les trois dimensions) ou à des puis quantiques (dans le cas d'un confinement dans deux dimensions).

Selon un mode de réalisation, le matériau semiconducteur des nanocristaux semiconducteurs est choisi parmi le groupe comprenant le séléniure de cadmium (CdSe), le phosphure d'indium (InP), le sulfure de cadmium (CdS), le sulfure de zinc (ZnS), le séléniure de zinc (ZnSe), le tellurure de cadmium (CdTe), le tellurure de zinc (ZnTe), l'oxyde de cadmium (CdO), l'oxyde de zinc et de cadmium (ZnCdO), le sulfure de zinc et de cadmium (CdZnS), le séléniure de zinc et de cadmium (CdZnSe), le sulfure d'argent et d'indium (AgInS₂), les pérovskites du type PbScX₃, où X est un atome d'halogène, notamment l'iode (I), le brome (Br) ou le chlore (Cl), et un mélange d'au moins deux de ces composés. Selon un mode de réalisation, le matériau semiconducteur des nanocristaux semiconducteurs est choisi parmi les matériaux cités dans la publication au nom de Le Blevenec et al. de Physica Status Solidi (RRL) - Rapid Research Letters Volume 8, No. 4, pages 349-352, avril 2014.

Selon un mode de réalisation, les dimensions des nanocristaux semiconducteurs sont choisies selon la longueur d'onde recherchée du rayonnement émis par les nanocristaux semiconducteurs. A titre d'exemple, des nanocristaux de CdSe dont la taille moyenne est de l'ordre de 3,6 nm sont adaptés à convertir de la lumière bleue en lumière rouge et des nanocristaux de CdSe dont la taille moyenne est de l'ordre de 1,3 nm sont adaptés à convertir de la lumière bleue en lumière verte. Selon un autre mode de réalisation, la composition des nanocristaux semiconducteurs est choisie selon la longueur d'onde recherchée du rayonnement émis par les nanocristaux semiconducteurs.

La matrice est en un matériau au moins en partie transparent au rayonnement émis par la diode électroluminescente DEL et au rayonnement émis par les particules photoluminescentes. La matrice est, par exemple, en silice. La matrice est, par exemple, en n'importe quel polymère au moins en partie transparent, notamment en silicone, en époxy ou en acide polyacétique (PLA). La matrice peut être en un polymère au moins en partie transparent utilisé avec les imprimantes tridimensionnelles, tels que le PLA. Selon un mode de réalisation, la matrice contient de 2 % à 90 %, de préférence de 10 % à 60 %, en poids de nanocristaux, par exemple environ 30 % en poids de nanocristaux. La matrice peut en outre contenir des particules diffusantes, notamment des particules de TiO₂, ayant par exemple un diamètre compris entre 100 nm et 300 nm.

Des simulations ont été réalisées pour le dispositif optoélectronique 40 représenté en figure 3 avec les paramètres de simulation décrits précédemment pour l'obtention des courbes de la figure 2.

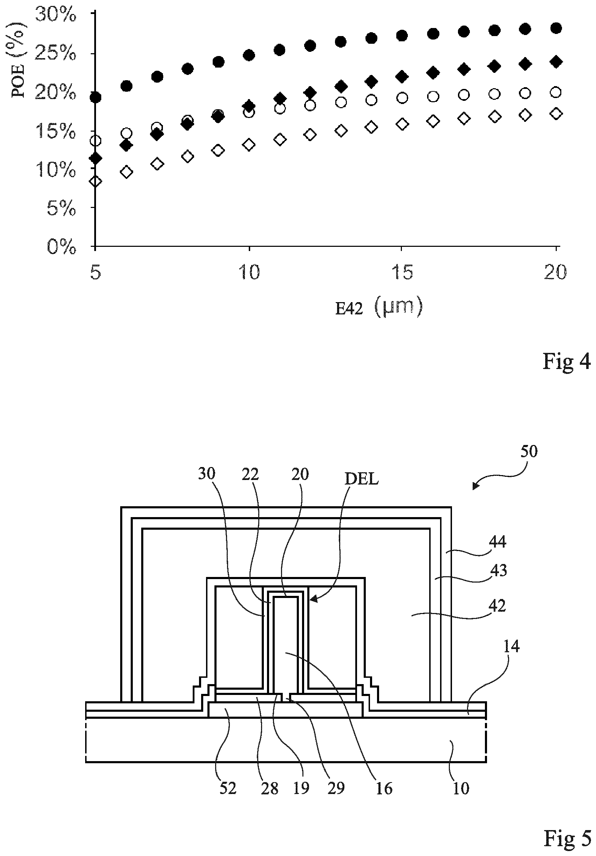

La figure 4 représente des courbes d'évolution de l'efficacité optique de pixel POE du dispositif optoélectronique 40 de la figure 3 en fonction de l'épaisseur E42 de la couche photoluminescente 42. L'efficacité optique de pixel correspond au rapport entre la puissance optique émise vers l'espace libre (incluant les pertes de conversion) et la puissance optique générée par la diode électroluminescente. Les simulations indiquées par des losanges ont été obtenues lorsque le support 10 correspond à un matériau opaque et mat entre les diodes électroluminescentes, c'est-à-dire un matériau présentant une réflexion sensiblement lambertienne. Les simulations indiquées par des cercles ont été obtenues lorsque le support 10 correspond à un miroir entre les diodes électroluminescentes, c'est-à-dire présentant une réflexion sensiblement spéculaire. Les courbes indiquées par des cercles ou losanges creux ont été obtenues lorsque l'indice de réfraction de la couche 43 était égal à 1,5 et les courbes indiquées par des cercles ou losanges pleins ont été obtenues lorsque l'indice de réfraction de la couche 43 était égal à 1. Plus l'indice de réfraction de la couche isolante 43 tend vers 1, plus l'efficacité optique de pixel POE est augmentée. Il apparaît en outre que la contribution due aux variations de l'indices de réfraction de la couche 43 dans le POE diminue lorsque l'épaisseur de la couche photoluminescente augmente 42. Il apparaît en outre que pour une épaisseur de la couche photoluminescente 42 supérieure à 15 µm environ, les variations de l'épaisseur de la couche photoluminescente 42 influe peu sur le POE.

La figure 5 est une vue en coupe, partielle et schématique, d'un autre mode de réalisation d'un dispositif optoélectronique 50 à microfils ou nanofils. Le dispositif optoélectronique 50 comprend l'ensemble des éléments du dispositif optoélectronique 40 représenté en figure 3 à la différence que, pour chaque diode électroluminescente DEL, le dispositif 50 comprend en outre un plot conducteur 52 interposé entre la diode électroluminescente DEL et le support 10, que la couche isolante 14 recouvre les bords latéraux du plot conducteur 52, que la coque 22 et l'électrode 30 ne recouvre pas la paroi d'extrémité inférieure 19 du fil 16 mais la paroi d'extrémité supérieure 20 du fil 16, que la couche isolante 28 est interposée entre le plot conducteur 52 et la couche d'électrode 30, et que la protubérance 29 connecte le fil 16 au plot conducteur 52.

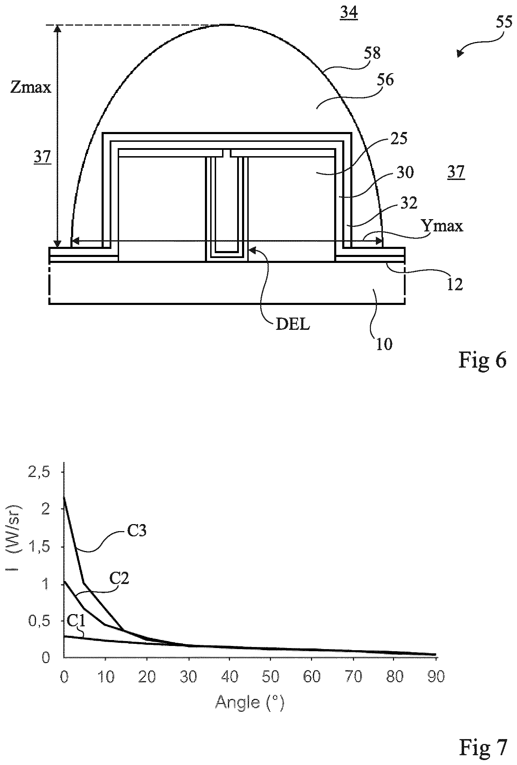

La figure 6 est une vue en coupe, partielle et schématique, d'un autre mode de réalisation d'un dispositif optoélectronique 55 à microfils ou nanofils. Le dispositif optoélectronique 55 comprend l'ensemble des éléments du dispositif optoélectronique 5 représenté en figure 1 et comprend, en outre, pour chaque diode électroluminescente DEL, une lentille 56 qui recouvre complètement le bloc d'encapsulation 25. En particulier, la lentille 56 recouvre la face supérieure du bloc d'encapsulation 25 et la paroi latérale du bloc d'encapsulation 25. Selon un mode de réalisation, la lentille 56 comprend une face extérieure 58 au contact de l'air 34 qui a en moins en partie sensiblement la forme d'une parabole dans un plan de coupe contenant l'axe du fil 16. L'interstice d'air 37 est présent et interposé entre deux lentilles 56 recouvrant les diodes électroluminescentes DEL d'une paire de diodes électroluminescentes adjacentes.

La lentille 56 peut être réalisée en un matériau organique ou inorganique, notamment les matériaux décrits précédemment pour former le bloc d'encapsulation 25 et/ou la matrice de la couche photoluminescente 42. La lentille 56 permet d'améliorer la directivité de la lumière émise par le dispositif optoélectronique 55. L'épaisseur Zmax de la lentille 56 correspond à la distance maximale entre la couche d'électrode 30 et la face 58. La largeur Ymax de la lentille 56 correspond à la distance maximale de la lentille 56 mesurée parallèlement à la face 12 du support 10. Selon un mode de réalisation, l'épaisseur Zmax est comprise entre 8 µm et 50 µm. Selon un mode de réalisation, la largeur Ymax est comprise entre 8 µm et 50 µm. De préférence, l'indice de réfraction de la lentille 56 est compris entre 1,4 et 1,5.

Selon un mode de réalisation, le support 10 est réfléchissant pour le rayonnement émis par la diode électroluminescente DEL et la paroi latérale de la lentille 56, sur une portion inférieure de la lentille 56, est entourée par une couche réfléchissante pour le rayonnement émis par la diode électroluminescente DEL.

Des simulations ont été réalisées pour le dispositif optoélectronique 55 représenté en figure 6 avec les paramètres de simulation décrits précédemment pour l'obtention des courbes de la figure 2. La lentille 56 était réalisée en matériau d'indice de réfraction égal à 1,45. Pour les simulations, la largeur maximale Ymax de la lentille 56 était égale à l'épaisseur maximale Zmax de la lentille 56.

La figure 7 représente des courbes C1, C2 et C3 d'évolution de l'intensité énergétique I du rayonnement émis par le dispositif optoélectronique 55 de la figure 6 selon une direction donnée en fonction de l'inclinaison Angle de ladite direction avec la face 12 supérieure du support 10 lorsque la lentille 56 a une épaisseur maximale Zmax égale à respectivement 6 µm, 12 µm et 18 µm. Comme cela apparaît sur la figure 7, l'intensité énergétique aux faibles incidences, c'est-à-dire pour un rayonnement s'échappant de façon sensiblement orthogonale à la face 12 du support 10, augmente lorsque l'épaisseur maximale Zmax de la lentille 56 augmente.

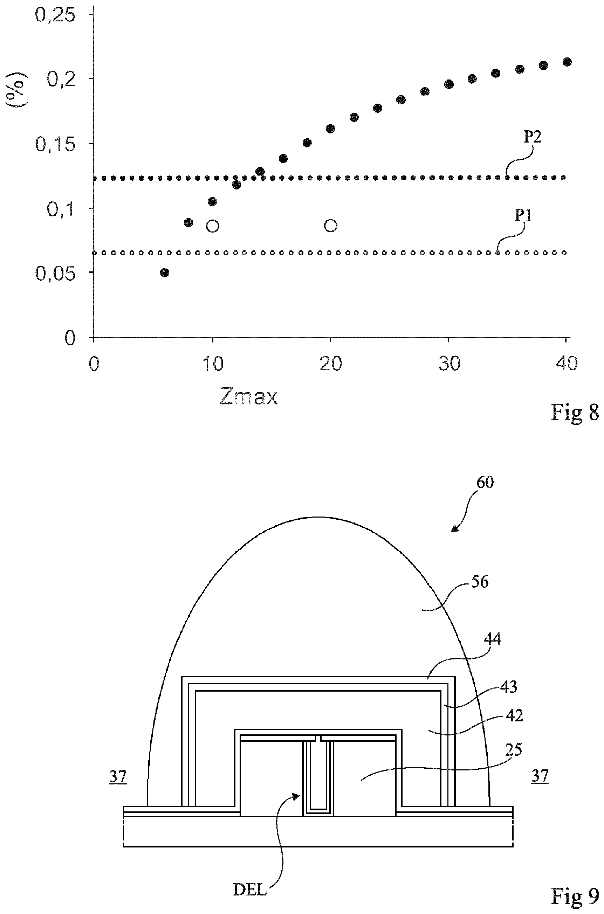

La figure 8 représente une courbe d'évolution de la puissance lumineuse P émise par le dispositif optoélectronique 55 de la figure 6 dans un cône d'émission, d'axe perpendiculaire à la face 12 du support 10 et dont le demi-angle au sommet est de 20°, en fonction de l'épaisseur maximale Zmax de la lentille 56. Les simulations indiquées par des grands cercles pleins noirs ont été obtenues avec une lentille 56 dont la face externe 58 correspond à un paraboloïde. A titre de comparaison, deux simulations indiquées par les grands cercles creux ont été obtenues avec des lentilles de forme pyramidale. Comme cela apparaît sur la figure 8, la puissance lumineuse dans le cône d'émission augmente lorsque l'épaisseur maximale Zmax de la lentille 56 augmente. A titre de comparaison, la droite P1 représentée par des petits cercles creux représente la puissance lumineuse P émise, dans le cône d'émission défini précédemment, en l'absence de la lentille 56 et la droite P2 représentée par des petits cercles pleins représente la puissance lumineuse P qui serait émise, dans le cône d'émission défini précédemment, par un émetteur lambertien.

La figure 9 est une vue en coupe, partielle et schématique, d'un autre mode de réalisation d'un dispositif optoélectronique 60 à microfils ou nanofils. Le dispositif optoélectronique 60 comprend l'ensemble des éléments du dispositif optoélectronique 40 représenté en figure 3 et comprend, en outre, la lentille 56 du dispositif optoélectronique 55 représenté en figure 6. Dans ce mode de réalisation, la lentille 56 recouvre complètement le bloc d'encapsulation 25, la couche photoluminescente 42 étant interposée entre le bloc d'encapsulation 25 et la lentille 56.

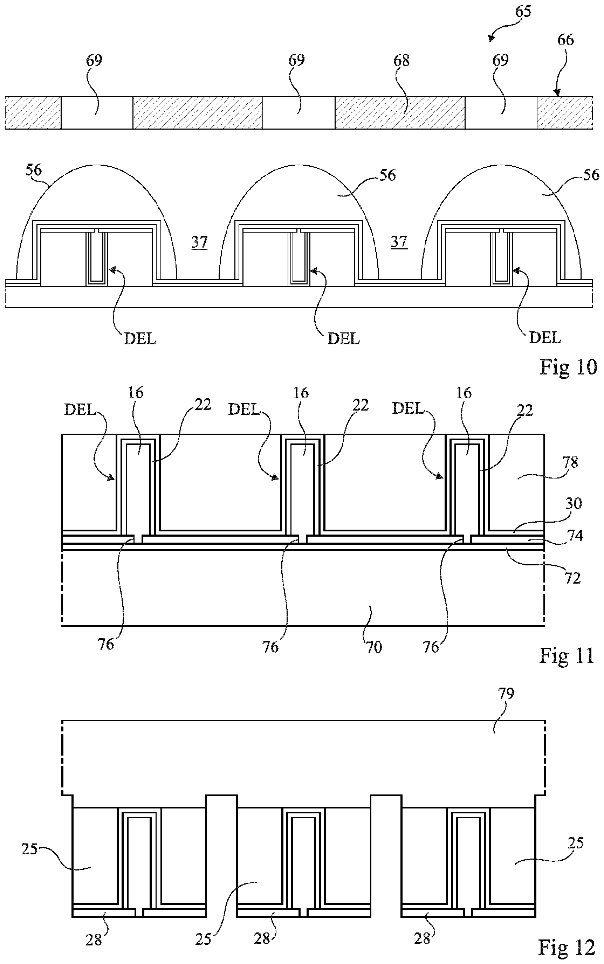

La figure 10 est une vue en coupe, partielle et schématique, d'un autre mode de réalisation d'un dispositif optoélectronique 65 à microfils ou nanofils. Le dispositif optoélectronique 65 comprend l'ensemble des éléments du dispositif optoélectronique 55 représenté en figure 6, trois diodes électroluminescentes DEL étant représentées, et comprend, en outre, un filtre angulaire 66 recouvrant les diodes électroluminescentes DEL. Le filtre angulaire 66 est configuré pour bloquer les rayons émis par les diodes électroluminescentes DEL et les rayons de la lumière ambiante à l'extérieur du dispositif optoélectronique 65 dont l'incidence par rapport à une direction de référence, par exemple une direction orthogonale à la face 12 du support 10, est dans une première plage d'incidences et à laisser passer des rayons dont la direction est dans au moins une deuxième plage d'incidences distincte de la première plage d'incidences. Dans le présent mode de réalisation, le filtre angulaire 66 comprend une couche 68 opaque à la lumière visible, de préférence absorbant la lumière visible, et comprenant des ouvertures traversantes 69. Les ouvertures traversantes 69 peuvent être formées à l'aplomb des diodes électroluminescentes DEL selon la direction de référence.

De préférence, chaque diode électroluminescente DEL est recouverte d'une lentille 56 comme cela est représenté en figure 10. Le filtre angulaire 66 est maintenu écarté du support 10 par des entretoises non représentées, un film d'air 34 étant présent entre le filtre angulaire 66 et les lentilles 56. Comme une partie importante du rayonnement qui s'échappe des lentilles 56 présente une faible incidence par rapport à la direction de référence, l'essentiel de ce rayonnement traverse le filtre angulaire 66 sans être bloqué. Inversement, l'essentiel du rayonnement dû à la lumière ambiante est bloqué par le filtre angulaire 66. Ceci permet de réduire les réflexions indésirables de la lumière ambiante sur des éléments réfléchissants du dispositif optoélectronique 65, par exemple des pistes métalliques. Ceci permet en outre d'améliorer le contraste du dispositif optoélectronique 65.

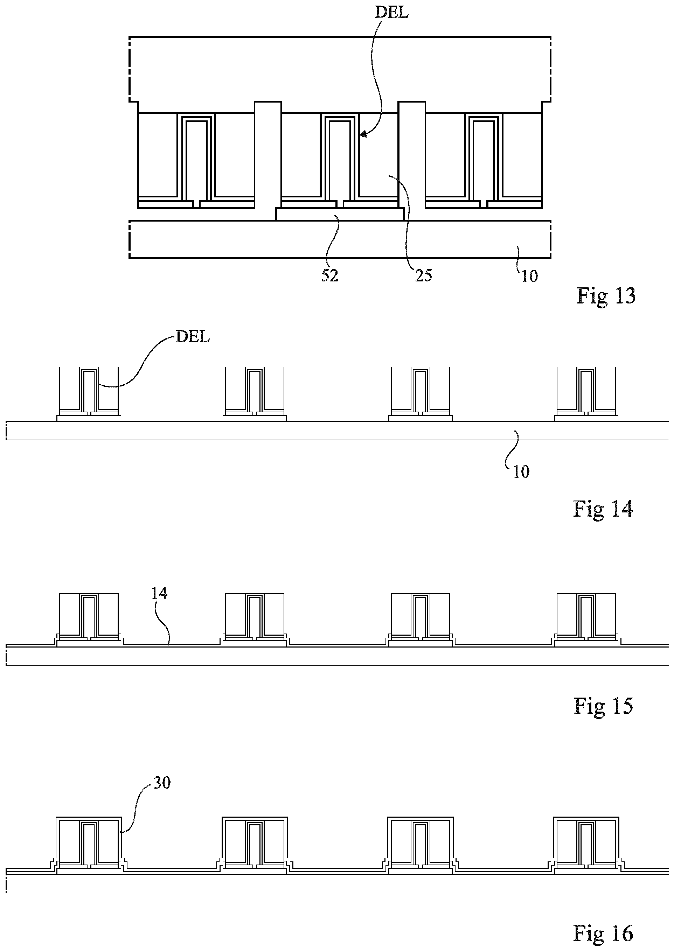

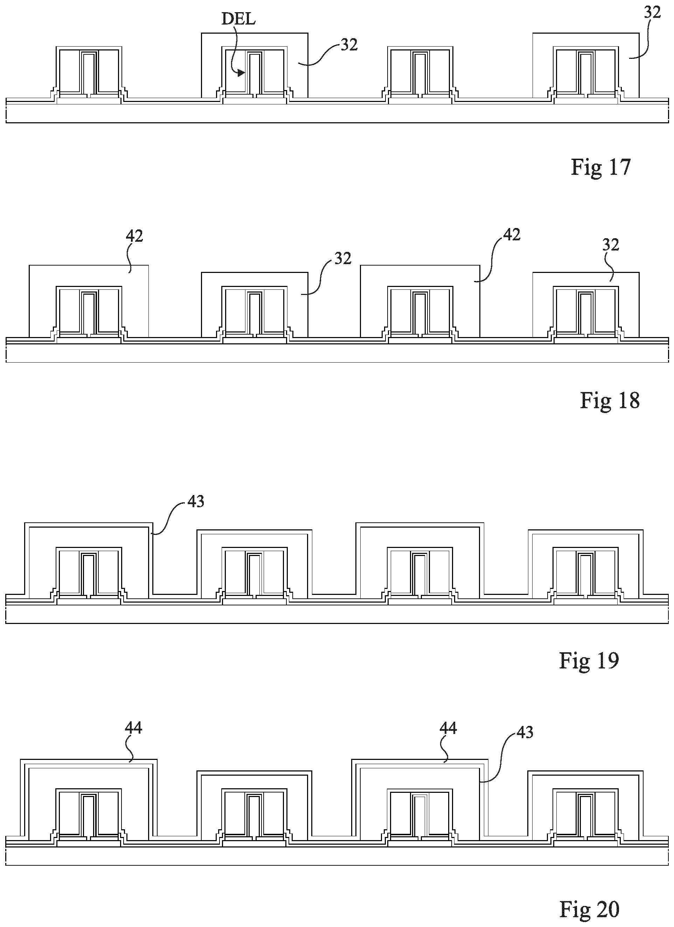

Les figures 11 à 20 sont des vues en coupe, partielles et schématiques, de structures obtenues à des étapes successives d'un mode de réalisation d'un procédé de fabrication du dispositif optoélectronique 50 représenté en figure 5. Le procédé comprend les étapes suivantes :
1) Formation des diodes électroluminescentes DEL (figure 11). Les diodes électroluminescentes DEL peuvent être formées sur un substrat 70 recouvert d'une couche de nucléation 72, également appelée couche de germination, et d'une couche 74 isolante électriquement recouvrant la couche de nucléation 72 et comprenant des ouvertures traversantes 76 exposant des parties de la couche de nucléation 72 aux emplacement souhaités de formation des diodes électroluminescentes DEL. La couche de germination 72 est une couche qui favorise la croissance des fils. La couche de germination 72, les fils 16, les coques 22 et la couche d'électrode 30 peuvent être déposés par un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy), l'épitaxie en phase vapeur aux hydrures (HVPE, acronyme anglais pour Hydride Vapor Phase Epitaxy) peuvent être utilisés ou un procédé de dépôt de couche mince atomique (ALD, acronyme anglais pour Atomic Layer Déposition). En outre, des procédés tels que l'évaporation ou la pulvérisation cathodique réactive peuvent être utilisés. Un procédé plus détaillé de fabrication des diodes électroluminescentes est décrit dans le brevet US 9 537 044. Une couche 78 du matériau composant les blocs d'encapsulation 25 est déposée sur l'ensemble de la structure, par exemple par un procédé de dépôt à la tournette, par un procédé d'impression par jet ou par un procédé de sérigraphie. Lorsque la couche d'encapsulation 78 est un oxyde, elle peut être déposée par CVD. Des portions de la couche d'électrode 30 sont exposées en surface de la couche d'encapsulation 78.
2) Fixation de la structure obtenue à l'étape précédente à une poignée 79 retrait du substrat 70 et de la couche de nucléation 72 et découpe partielle de la structure obtenue, du côté de la couche isolante 74, pour délimiter les blocs d'encapsulation 25 et les couches isolantes 28 (figure 12). La fixation à la poignée 79 peut être réalisée par collage moléculaire ou en utilisant un matériau de collage intermédiaire. Le retrait du substrat 70 peut être réalisée par planarisation mécano-chimique (CMP, sigle anglais pour Chemical-Mechanical Planarization). Les découpes permettant la délimitation des blocs d'encapsulation 25 et des couches isolantes 28 peuvent être réalisées par gravure ou par sciage.
3) Fixation au support 10 de diodes électroluminescentes de la structure obtenue à l'étape précédente (figure 13). La fixation peut être réalisée par une liaison de type "Flip-Chip". Selon un autre mode de réalisation, la fixation peut être réalisée par collage direct, également appelé collage moléculaire, des diodes électroluminescentes aux plots conducteurs 52 prévus sur le support 10. Comme cela est représenté en figure 13, seules certaines des diodes électroluminescentes de la structure représentée en figure 12 sont fixées au support 10. La figure 14 représente le résultat obtenu une fois que toutes les diodes électroluminescentes sont fixées aux emplacements souhaités sur le support 10.
4) Formation de la couche isolante 14 (figure 15). Ceci peut être réalisée par un dépôt conforme de la couche isolante sur la totalité de la structure représentée en figure 14 et le retrait de portions de cette couche conforme pour former la couche isolante 14.
5) Formation de la couche d'électrode 30, par exemple par dépôt conforme (figure 16).
6) formation éventuelle pour les diodes électroluminescentes DEL ne comprenant pas de couche photoluminescente 42 de la couche 32 recouvrant la couche d'électrode 30 (figure 17).
7) formation des couches photoluminescentes 42 pour les autres diodes électroluminescentes DEL (figure 18), par exemple par impression directe du matériau composant les couches photoluminescentes 42 aux emplacements souhaités, par exemple par impression par jet d'encre, impression par aérosol, microtamponnage, photogravure, sérigraphie, flexographie, revêtement par pulvérisation, ou dépôt de gouttes.
8) Formation de la couche isolante 43, par exemple par dépôt conforme (figure 19).
9) Formation des filtres 44 (figure 20).

Dans le cas de dispositifs optoélectroniques comprenant des lentilles 56 recouvrant les diodes électroluminescentes, les lentilles 56 peuvent être formées par le dépôt d'une couche du matériau composant les lentilles sur les diodes électroluminescentes et la gravure de cette couche ou le formage de cette couche pour obtenir les lentilles 56.

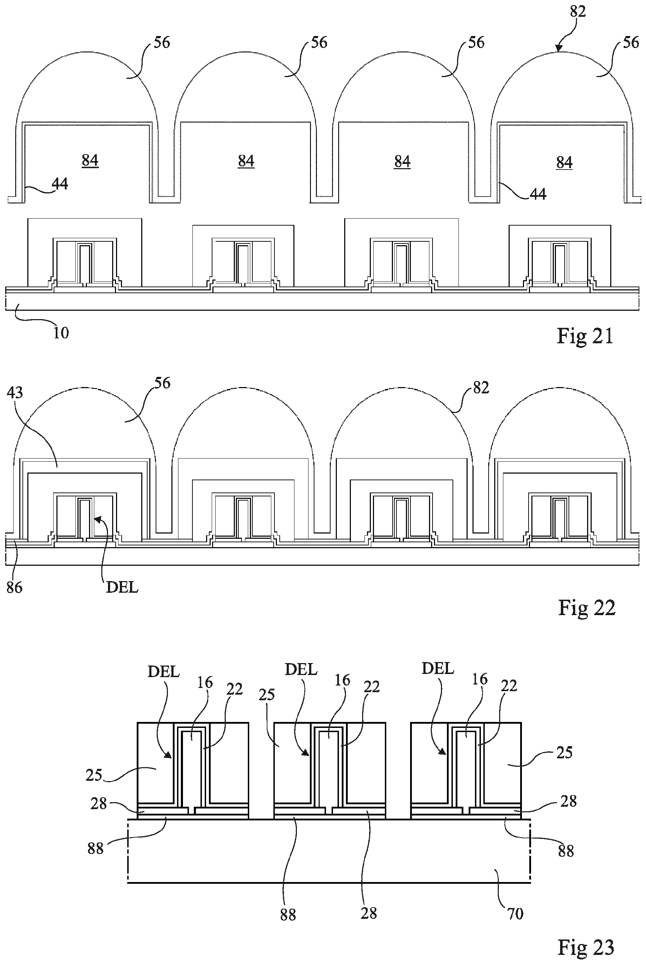

Les figures 21 et 22 sont des vues en coupe, partielles et schématiques, de structures obtenues à des étapes successives d'un mode de réalisation d'un procédé de fabrication d'un dispositif optoélectronique correspond à une variante du dispositif optoélectronique 60 représenté en figure 9. Dans ce mode de réalisation, les lentilles 56 sont formées au préalable séparément de la structure comprenant les diodes électroluminescente. En figure 21, les lentilles 56 forment une structure monobloc 82, par exemple obtenue par moulage. Chaque lentille 56 comprend un logement 84 destiné à recevoir une diode électroluminescente DEL. Les filtres 44 peuvent être formés dans certains logements. La structure monobloc 82 est ensuite fixée au support 10 (figure 22), par exemple en utilisant un matériau de collage 86. Dans le présent mode de réalisation, les dimensions des logements 84 sont plus importantes que les dimensions des diodes électroluminescentes DEL de sorte que, lorsque la structure monobloc 82 est fixée au support 10, il reste un interstice d'air entre chaque lentille 56 et la couche photoluminescente 42 qui forme la couche 43 décrite précédemment.

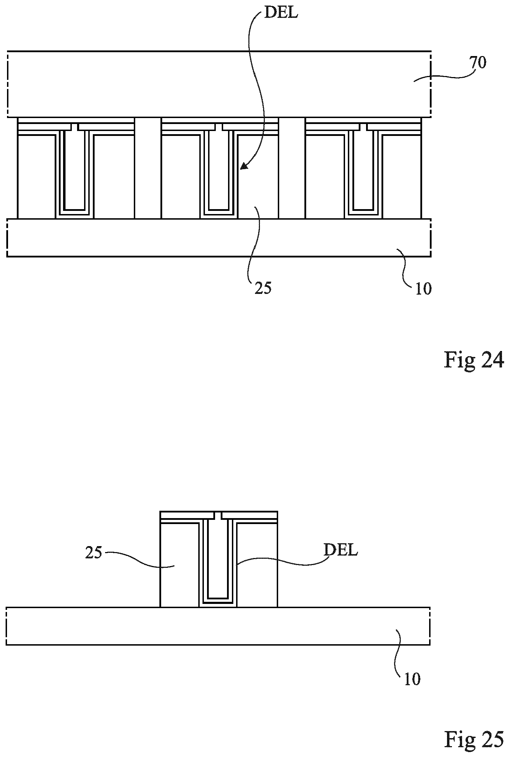

Les figures 23 à 25 sont des vues en coupe, partielles et schématiques, de structures obtenues à des étapes successives d'un mode de réalisation d'un procédé de fabrication du dispositif optoélectronique 5 représenté en figure 1. Le procédé comprend les étapes suivantes :
1)' Formation des diodes électroluminescentes DEL de façon analogue à ce qui a été décrit précédemment à l'étape 1) en relation avec la figure 11.
2)' Découpe partielle de la structure obtenue, du côté de la couche isolante 74, pour délimiter les blocs d'encapsulation 25, les couches isolantes 28 et de portions 88 de la couche de nucléation 72 (figure 23). Les découpes peuvent être réalisées par gravure ou par sciage.
3)' Fixation au support 10 de diodes électroluminescentes de la structure obtenue à l'étape précédente (figure 24). La fixation peut être réalisée comme cela a été décrit précédemment à l'étape 3) en relation avec la figure 13.
4)' Libération sélective du substrat 70 des diodes électroluminescentes DEL fixées au support 10 et retrait des portions 80 la couche de nucléation.

Les étapes ultérieures du procédé peuvent correspondre aux étapes décrites précédemment en relation avec les figures 14 à 22.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, la structure de la diode électroluminescente DEL du dispositif optoélectronique 50 représenté en figure 5 peut être mise en oeuvre avec le dispositif optoélectronique 5 représenté en figure 1, le dispositif optoélectronique 55 représenté en figure 6, le dispositif optoélectronique 60 représenté en figure 9 et le dispositif optoélectronique 65 représenté en figure 10. En outre, bien que dans les modes de réalisation décrits précédemment, chaque bloc d'encapsulation 25 soit représenté recouvrant une seule diode électroluminescente DEL, il est clair que chaque bloc d'encapsulation 25 peut recouvrir un groupe de diodes électroluminescentes, par exemple de 2 à 100 diodes électroluminescentes. Le bloc d'encapsulation 25 peut recouvrir chaque diode électroluminescente du groupe sur toute la paroi latérale 18 de la diode électroluminescente.

Enfin, la mise en oeuvre pratique des modes de réalisation et variantes décrits est à la portée de l'homme du métier à partir des indications fonctionnelles données ci-dessus.

## Revendications

1. Dispositif optoélectronique (5) comprenant :
- un support (10) comprenant une face (12) ;
- des diodes électroluminescentes (DEL) reposant sur la face et comprenant des éléments semiconducteurs (16) filaires, coniques, ou tronconiques ;
- pour chaque diode électroluminescente ou pour chaque groupe de diodes électroluminescentes, un bloc d'encapsulation (25) au moins partiellement transparent au rayonnement émis par les diodes électroluminescentes et recouvrant la diode électroluminescente sur toute la paroi latérale de la diode électroluminescente ou le groupe de diodes électroluminescentes sur toute la paroi latérale de chaque diode électroluminescente, l'épaisseur maximale du bloc d'encapsulation étant comprise entre 1 µm et 30 µm, des interstices d'air (37) étant présents entre les blocs d'encapsulation recouvrant des diodes électroluminescentes adjacentes ou des groupes adjacents de diodes électroluminescentes ; et
- une couche conductrice électriquement (30) recouvrant les blocs d'encapsulation et au contact de chaque diode électroluminescente,
dans lequel l'indice de réfraction du bloc d'encapsulation recouvrant au moins l'une des diodes électroluminescentes ou l'un des groupes de diodes électroluminescentes est compris entre 1,3 et 1,6.

2. Dispositif optoélectronique (5) comprenant :
- un support (10) comprenant une face (12) ;
- des diodes électroluminescentes (DEL) reposant sur la face et comprenant des éléments semiconducteurs (16) filaires, coniques, ou tronconiques ;
- pour chaque diode électroluminescente ou chaque groupe de diodes électroluminescentes, un bloc d'encapsulation (25) au moins partiellement transparent au rayonnement émis par les diodes électroluminescentes et recouvrant la diode électroluminescente sur toute la paroi latérale de la diode électroluminescente ou le groupe de diodes électroluminescentes sur toute la paroi latérale de chaque diode électroluminescente, l'épaisseur maximale du bloc d'encapsulation étant comprise entre 1 µm et 30 µm, des interstices d'air (37) étant présents entre les blocs d'encapsulation recouvrant des diodes adjacentes ou des groupes adjacents de diodes électroluminescentes ; et
- une couche conductrice électriquement (30) recouvrant les blocs d'encapsulation et au contact de chaque diode électroluminescente,
dans lequel le dispositif optoélectronique comprend, pour au moins l'un des blocs d'encapsulation, une couche diélectrique (32) conforme recouvrant le bloc d'encapsulation (25), au moins partiellement transparente au rayonnement émis par les diodes électroluminescentes, l'indice de réfraction du bloc d'encapsulation étant compris entre 1,8 et 2,2, l'épaisseur de la couche diélectrique étant comprise entre 200 nm et 5 µm, et l'indice de réfraction de la couche diélectrique étant compris entre 1,3 et 1,6.

3. 4. Dispositif optoélectronique selon la revendication 2, dans lequel la couche diélectrique (32) est interposée entre la couche conductrice électriquement (30) et le bloc d'encapsulation (25) ou dans lequel la couche conductrice électriquement (30) est interposée entre la couche diélectrique (32) et le bloc d'encapsulation (25).

4. Dispositif optoélectronique selon l'une quelconque des revendications 1 à 3, dans lequel chaque élément semiconducteur (16) est en un composé III-V.

5. Dispositif optoélectronique selon la revendication 4, dans lequel chaque élément semiconducteur (16) comprend du nitrure de gallium.

6. 7. Dispositif optoélectronique selon l'une quelconque des revendications 1 à 5, dans lequel le diamètre moyen de chaque élément semiconducteur (16) est compris entre 200 nm et 2 µm et dans lequel le diamètre moyen de chaque bloc d'encapsulation (25) est compris entre 3 µm et 30 µm.

7. Dispositif optoélectronique selon l'une quelconque des revendications 1 à 6, comprenant, en outre, pour au moins une diode électroluminescente (DEL), une couche photoluminescente (42) recouvrant le bloc d'encapsulation (25) .

8. Dispositif optoélectronique selon l'une quelconque des revendications 1 à 7, comprenant des lentilles (56) recouvrant les blocs d'encapsulation (25), les interstices d'air (37) étant présents entre les lentilles (26).

9. Dispositif optoélectronique selon la revendication 8, comprenant, en outre, un filtre angulaire (66) recouvrant les lentilles (56).

10. Dispositif optoélectronique selon la revendication 9, dans lequel le filtre angulaire (66) comprend une couche au moins partiellement opaque (68) à la lumière visible et traversée par des ouvertures (69).

11. Procédé de fabrication d'un dispositif optoélectronique (5) comprenant un support (10) comprenant une face (12) et des diodes électroluminescentes (DEL) reposant sur la face et comprenant des éléments semiconducteurs (16) filaires, coniques, ou tronconiques, le procédé comprenant la formation, pour chaque diode électroluminescente ou pour chaque groupe de diodes électroluminescentes, d'un bloc d'encapsulation (25) au moins partiellement transparent au rayonnement émis par les diodes électroluminescentes et recouvrant la diode électroluminescente sur toute la paroi latérale de la diode électroluminescente ou le groupe de diodes électroluminescentes sur toute la paroi latérale de chaque diode électroluminescente, l'épaisseur maximale du bloc d'encapsulation étant comprise entre 1 µm et 30 µm, des interstices d'air (37) étant présents entre les blocs d'encapsulation recouvrant des diodes électroluminescentes adjacentes ou des groupes adjacents de diodes électroluminescentes, et la formation d'une couche conductrice électriquement (30) recouvrant les blocs d'encapsulation et au contact de chaque diode électroluminescente,
dans lequel l'indice de réfraction du bloc d'encapsulation recouvrant au moins l'une des diodes électroluminescentes ou l'un des groupes de diodes électroluminescentes est compris entre 1,3 et 1,6.

12. 10. Procédé de fabrication d'un dispositif optoélectronique (5) comprenant un support (10) comprenant une face (12) et des diodes électroluminescentes (DEL) reposant sur la face et comprenant des éléments semiconducteurs (16) filaires, coniques, ou tronconiques, le procédé comprenant la formation, pour chaque diode électroluminescente ou pour chaque groupe de diodes électroluminescentes, d'un bloc d'encapsulation (25) au moins partiellement transparent au rayonnement émis par les diodes électroluminescentes et recouvrant la diode électroluminescente sur toute la paroi latérale de la diode électroluminescente ou le groupe de diodes électroluminescentes sur toute la paroi latérale de chaque diode électroluminescente, l'épaisseur maximale du bloc d'encapsulation étant comprise entre 1 µm et 30 µm, des interstices d'air (37) étant présents entre les blocs d'encapsulation recouvrant des diodes électroluminescentes adjacentes ou des groupes adjacents de diodes électroluminescentes, et la formation d'une couche conductrice électriquement (30) recouvrant les blocs d'encapsulation et au contact de chaque diode électroluminescente,
dans lequel le dispositif optoélectronique comprend, pour au moins l'un des blocs d'encapsulation, une couche diélectrique (32) conforme recouvrant le bloc d'encapsulation (25), et au moins partiellement transparente au rayonnement émis par les diodes électroluminescentes, l'indice de réfraction du bloc d'encapsulation étant compris entre 1,8 et 2,2, l'épaisseur de la couche diélectrique étant comprise entre 200 nm et 5 µm, et l'indice de réfraction de la couche diélectrique étant compris entre 1,3 et 1,6.

13. Procédé selon la revendication 11 ou 12, dans lequel, pour chaque diode électroluminescente (DEL) ou pour chaque groupe de diodes électroluminescentes, le bloc d'encapsulation (25) recouvre la diode électroluminescente ou chaque diode électroluminescente du groupe sur toute la paroi latérale (18) de la diode électroluminescente

14. Procédé selon l'une quelconque des revendications 11 à 13, comprenant la formation de lentilles (56) recouvrant les blocs d'encapsulation (25).

15. Procédé selon la revendication 14, comprenant la formation d'une structure monobloc comprenant les lentilles (56), chaque lentille comprenant un logement (84) et comprenant la fixation de la structure monobloc au support (10), les blocs d'encapsulation (25) étant insérés dans les logements (84).

## Patentansprüche

1. Optoelektronische Vorrichtung (5), die Folgendes aufweist:
- einen Träger (10) mit einer Fläche (12);
- lichtemittierende Dioden (DEL), die auf der Fläche liegen und Halbleiterelemente (16) in Form von Drähten, Kegeln oder Kegelstümpfen aufweisen;
- für jede lichtemittierende Diode oder jede Gruppe von lichtemittierenden Dioden einen Einkapselungsblock (25), der zumindest teilweise für die von den lichtemittierenden Dioden emittierte Strahlung transparent ist und die lichtemittierende Diode entlang der gesamten Seitenwand der lichtemittierende Diode oder die Gruppe von lichtemittierenden Dioden entlang der gesamten Seitenwand jeder lichtemittierende Diode bedeckt, wobei die maximale Dicke des Einkapselungsblocks zwischen 1 µm und 30 µm liegt, wobei zwischen Einkapselungsblöcken, die benachbarte lichtemittierenden Dioden oder benachbarte Gruppen von lichtemittierenden Dioden bedecken, Luftzwischenräume (37) vorhanden sind; und
- eine elektrisch leitende Schicht (30), die die Einkapselungsblöcke bedeckt und in Kontakt mit jeder lichtemittierenden Diode steht,
wobei der Brechungsindex des Einkapselungsblocks, der mindestens eine der lichtemittierenden Dioden oder eine der Gruppen von lichtemittierenden Dioden bedeckt, zwischen 1,3 und 1,6 liegt.

2. Optoelektronische Vorrichtung (5), die Folgendes aufweist:
- einen Träger (10) mit einer Fläche (12);
- lichtemittierende Dioden (DEL), die auf der Fläche liegen und Halbleiterelemente (16) in Form von Drähten, Kegeln oder Kegelstümpfen aufweisen;
- für jede lichtemittierende Diode oder jede Gruppe von lichtemittierenden Dioden einen Einkapselungsblock (25), der zumindest teilweise für die von den lichtemittierenden Dioden emittierte Strahlung transparent ist und die lichtemittierende Diode entlang der gesamten Seitenwand der lichtemittierenden Diode oder der Gruppe von lichtemittierenden Dioden entlang der gesamten Seitenwand jeder lichtemittierenden Diode bedeckt, wobei die maximale Dicke des Einkapselungsblocks zwischen 1 µm und 30 µm liegt, wobei zwischen den Einkapselungsblöcken, die benachbarte Dioden oder benachbarte Gruppen von lichtemittierenden Dioden bedecken, Luftzwischenräume (37) vorhanden sind; und
- eine elektrisch leitende Schicht (30), die die Einkapselungsblöcke bedeckt und in Kontakt mit jeder lichtemittierenden Diode steht,
wobei die optoelektronische Vorrichtung für mindestens einen der Einkapselungsblöcke eine konforme dielektrische Schicht (32) aufweist, die den Einkapselungsblock (25) bedeckt und zumindest teilweise für die von den lichtemittierenden Dioden emittierte Strahlung transparent ist, wobei der Brechungsindex des Einkapselungsblocks zwischen 1,8 und 2,2 liegt, die Dicke der dielektrischen Schicht zwischen 200 nm und 5 µm liegt und der Brechungsindex der dielektrischen Schicht zwischen 1,3 und 1,6 liegt.

3. Optoelektronische Vorrichtung nach Anspruch 2, wobei die dielektrische Schicht (32) zwischen der elektrisch leitenden Schicht (30) und dem Einkapselungsblock (25) angeordnet ist oder wobei die elektrisch leitende Schicht (30) zwischen der dielektrischen Schicht (32) und dem Einkapselungsblock (25) angeordnet ist.

4. Optoelektronische Vorrichtung nach einem der Ansprüche 1 bis 3, wobei jedes Halbleiterelement (16) eine III-V-Verbindung ist.

5. Optoelektronisches Bauelement nach Anspruch 4, wobei jedes Halbleiterelement (16) Galliumnitrid aufweist.

6. Optoelektronisches Bauelement nach einem der Ansprüche 1 bis 5, wobei der mittlere Durchmesser jedes Halbleiterelements (16) zwischen 200 nm und 2 µm liegt und wobei der mittlere Durchmesser jedes Einkapselungsblocks (25) zwischen 3 µm und 30 µm liegt.

7. Optoelektronische Vorrichtung nach einem der Ansprüche 1 bis 6, die ferner für mindestens eine lichtemittierende Diode (DEL) eine den Einkapselungsblock (25) bedeckende photolumineszente Schicht (42) aufweist.

8. Optoelektronische Vorrichtung nach einem der Ansprüche 1 bis 7, aufweisend Linsen (56), die die Einkapselungsblöcke (25) abdecken, wobei die Luftzwischenräume (37) zwischen den Linsen (26) vorhanden sind.

9. Optoelektronische Vorrichtung nach Anspruch 8, die ferner einen die Linsen (56) abdeckenden Winkelfilter (66) aufweist.

10. Optoelektronische Vorrichtung nach Anspruch 9, wobei der Winkelfilter (66) eine für das sichtbare Licht zumindest teilweise undurchlässige (68) Schicht mit Öffnungen (69) aufweist.

11. Verfahren zur Herstellung einer optoelektronischen Vorrichtung (5) mit einem Träger (10), der eine Fläche (12) und auf der Fläche liegende lichtemittierende Dioden (DEL) mit Halbleiterelementen (16) in Form von Drähten, Kegeln oder Kegelstümpfen aufweist, wobei das Verfahren für jede lichtemittierende Diode oder jede Gruppe von lichtemittierenden Dioden das Ausbilden eines Einkapselungsblocks (25) aufweist, der zumindest teilweise für die von den lichtemittierenden Dioden emittierte Strahlung transparent ist und der die lichtemittierende Diode entlang der gesamten Seitenwand der lichtemittierenden Diode oder der Gruppe von lichtemittierenden Dioden entlang der gesamten Seitenwand jeder lichtemittierenden Diode bedeckt, wobei die maximale Dicke des Einkapselungsblocks zwischen 1 µm und 30 µm liegt, wobei Luftzwischenräume (37) zwischen den Einkapselungsblöcken vorhanden sind, die benachbarte lichtemittierende Dioden oder benachbarte Gruppen von lichtemittierenden Dioden bedecken, sowie das Ausbilden einer elektrisch leitenden Schicht (30), die die Einkapselungsblöcke bedeckt und in Kontakt mit jeder lichtemittierenden Diode steht,
wobei der Brechungsindex des Einkapselungsblocks, der mindestens eine der lichtemittierenden Dioden oder eine der Gruppen von lichtemittierenden Dioden bedeckt, zwischen 1,3 und 1,6 liegt.

12. Verfahren zur Herstellung einer optoelektronischen Vorrichtung (5) mit einem Träger (10), der eine Fläche (12) und auf der Fläche liegende lichtemittierende Dioden (DEL) mit Halbleiterelementen (16) in Form von Drähten, Kegeln oder Kegelstümpfen aufweist, wobei das Verfahren für jede lichtemittierende Diode oder jede Gruppe von lichtemittierenden Dioden das Ausbilden eines Einkapselungsblocks (25) aufweist, der zumindest teilweise für die von den lichtemittierenden Dioden emittierte Strahlung transparent ist und der die lichtemittierende Diode entlang der gesamten Seitenwand der lichtemittierenden Diode oder der Gruppe von lichtemittierenden Dioden entlang der gesamten Seitenwand jeder lichtemittierenden Diode bedeckt, wobei die maximale Dicke des Einkapselungsblocks zwischen 1 µm und 30 µm liegt, wobei Luftzwischenräume (37) zwischen den Einkapselungsblöcken vorhanden sind, die benachbarte lichtemittierende Dioden oder benachbarte Gruppen von lichtemittierenden Dioden bedecken, sowie das Ausbilden einer elektrisch leitenden Schicht (30), die die Einkapselungsblöcke bedeckt und in Kontakt mit jeder lichtemittierenden Diode steht,
wobei die optoelektronische Vorrichtung für mindestens einen der Einkapselungsblöcke eine konforme dielektrische Schicht (32) aufweist, die den Einkapselungsblock (25) bedeckt und zumindest teilweise für die von den lichtemittierenden Dioden emittierte Strahlung transparent ist, wobei der Brechungsindex des Einkapselungsblocks zwischen 1,8 und 2,2 liegt, die Dicke der dielektrischen Schicht zwischen 200 nm und 5 µm liegt und der Brechungsindex der dielektrischen Schicht zwischen 1,3 und 1,6 liegt.

13. Verfahren nach Anspruch 11 oder 12, wobei für jede lichtemittierende Diode (DEL) oder jede Gruppe von lichtemittierenden Dioden der Einkapselungsblock (25) die lichtemittierende Diode oder jede lichtemittierende Diode der Gruppe entlang der gesamten Seitenwand (18) der lichtemittierenden Diode bedeckt.

14. Verfahren nach einem der Ansprüche 11 bis 13, aufweisend das Ausbilden von Linsen (56), die die Einkapselungsblöcke (25) bedecken.

15. Verfahren nach Anspruch 14, aufweisend das Ausbilden einer Monoblockstruktur, die die Linsen (56) aufweist, wobei jede Linse einen Steckplatz (84) aufweist, und das Befestigen der Monoblockstruktur am Träger (10), wobei die Einkapselungsblöcke (25) in die Steckplätze (84) eingesetzt werden.

## Claims

1. An optoelectronic device (5) comprising:
- a support (10) comprising a face (12);
- light-emitting diodes (DEL) lying on the face and comprising semiconductor elements (16) in the form of wires, cones, or truncated cones;
- for each light-emitting diode or each group of light-emitting diodes, an encapsulation block (25) at least partially transparent to the radiation emitted by the light-emitting diodes and covering the light-emitting diode along the entire lateral wall of the light-emitting diode or the group of light-emitting diodes along the entire lateral wall of each light-emitting diode, the maximum thickness of the encapsulation block being comprised between 1 µm and 30 µm, interstices of air (37) being present between the encapsulation blocks covering adjacent light-emitting diodes or adjacent groups of light-emitting diodes; and
- an electrically conductive layer (30) covering the encapsulation blocks and in contact with each light-emitting diode,
wherein the refractive index of the encapsulation block covering at least one of the light-emitting diodes or one of the groups of light-emitting diodes is comprised between 1.3 and 1.6.

2. An optoelectronic device (5) comprising:
- a support (10) comprising a face (12);
- light-emitting diodes (DEL) lying on the face and comprising semiconductor elements (16) in the form of wires, cones, or truncated cones;
- for each light-emitting diode or each group of light-emitting diodes, an encapsulation block (25) at least partially transparent to the radiation emitted by the light-emitting diodes and covering the light-emitting diode along the entire lateral wall of the light-emitting diode or the group of light-emitting diodes along the entire lateral wall of each light-emitting diode, the maximum thickness of the encapsulation block being comprised between 1 µm and 30 µm, interstices of air (37) being present between the encapsulation blocks covering adjacent diodes or adjacent groups of light-emitting diodes; and
- an electrically conductive layer (30) covering the encapsulation blocks and in contact with each light-emitting diode,
wherein the optoelectronic device comprises, for at least one of the encapsulation blocks, a conformal dielectric layer (32) covering the encapsulation block (25), at least partially transparent to the radiation emitted by the light-emitting diodes, the refractive index of the encapsulation block being comprised between 1.8 and 2.2, the thickness of the dielectric layer being comprised between 200 nm and 5 µm, and the refractive index of the dielectric layer being comprised between 1.3 and 1.6.

3. The optoelectronic device according to claim 2, wherein the dielectric layer (32) is placed between the electrically conductive layer (30) and the encapsulation block (25) or wherein the electrically conductive layer (30) is placed between the dielectric layer (32) and the encapsulation block (25).

4. The optoelectronic device according to any one of claims 1 to 3, wherein each semiconductor element (16) is a III-V compound.

5. The optoelectronic device according to claim 4, wherein each semiconductor element (16) comprises gallium nitride.

6. The optoelectronic device according to any one of claims 1 to 5, wherein the average diameter of each semiconductor element (16) is comprised between 200 nm and 2 µm and wherein the average diameter of each encapsulation block (25) is comprised between 3 µm and 30 µm.

7. The optoelectronic device according to any one of claims 1 to 6, comprising, moreover, for at least one light-emitting diode (DEL), a photoluminescent layer (42) covering the encapsulation block (25).

8. The optoelectronic device according to any one of claims 1 to 7, comprising lenses (56) covering the encapsulation blocks (25), the interstices of air (37) being present between the lenses (26).

9. The optoelectronic device according to claim 8, comprising, moreover, an angular filter (66) covering the lenses (56).

10. The optoelectronic device according to claim 9, wherein the angular filter (66) comprises a layer at least partially opaque (68) to the visible light and comprising openings (69).

11. A method for manufacturing an optoelectronic device (5) comprising a support (10) comprising a face (12) and light-emitting diodes (DEL) lying on the face and comprising semiconductor elements (16) in the form of wires, cones, or truncated cones, the method comprising the formation, for each light-emitting diode or each group of light-emitting diodes, of an encapsulation block (25) at least partially transparent to the radiation emitted by the light-emitting diodes and covering the light-emitting diode along the entire lateral wall of the light-emitting diode or the group of light-emitting diodes along the entire lateral wall of each light-emitting diode, the maximum thickness of the encapsulation block being comprised between 1 µm and 30 µm, interstices of air (37) being present between the encapsulation blocks covering adjacent light-emitting diodes or adjacent groups of light-emitting diodes, and the formation of an electrically conductive layer (30) covering the encapsulation blocks and in contact with each light-emitting diode,
wherein the refractive index of the encapsulation block covering at least one of the light-emitting diodes or one of the groups of light-emitting diodes is comprised between 1.3 and 1.6.

12. A method for manufacturing an optoelectronic device (5) comprising a support (10) comprising a face (12) and light-emitting diodes (DEL) lying on the face and comprising semiconductor elements (16) in the form of wires, cones, or truncated cones, the method comprising the formation, for each light-emitting diode or each group of light-emitting diodes, of an encapsulation block (25) at least partially transparent to the radiation emitted by the light-emitting diodes and covering the light-emitting diode along the entire lateral wall of the light-emitting diode or the group of light-emitting diodes along the entire lateral wall of each light-emitting diode, the maximum thickness of the encapsulation block being comprised between 1 µm and 30 µm, interstices of air (37) being present between the encapsulation blocks covering adjacent light-emitting diodes or adjacent groups of light-emitting diodes, and the formation of an electrically conductive layer (30) covering the encapsulation blocks and in contact with each light-emitting diode,
wherein the optoelectronic device comprises, for at least one of the encapsulation blocks, a conformal dielectric layer (32) covering the encapsulation block (25) and at least partially transparent to the radiation emitted by the light-emitting diodes, the refractive index of the encapsulation block being comprised between 1.8 and 2.2, the thickness of the dielectric layer being comprised between 200 nm and 5 µm, and the refractive index of the dielectric layer being comprised between 1.3 and 1.6.

13. The method according to claim 11 or 12, wherein, for each light-emitting diode (DEL) or each group of light-emitting diodes, the encapsulation block (25) covers the light-emitting diode or each light-emitting diode of the group along the entire lateral wall (18) of the light-emitting diode.

14. The method according to any one of claims 11 to 13, comprising the formation of lenses (56) covering the encapsulation blocks (25).

15. The method according to claim 14, comprising the formation of a monobloc structure comprising the lenses (56), each lens comprising a slot (84) and comprising the fixation of the monobloc structure to the support (10), the encapsulation blocks (25) being inserted in the slots (84).
